# EUROPEAN PATENT APPLICATION

(11) **EP 0 727 926 A2**
(43) Date of publication of application: **21.08.1996**
(21) Application number: 96300569.9
(22) Date of filing: 26.01.1996
(51) Int. Cl.: H05K 3/46, H05K 3/40

(54) **Multilayer printed writing board and method of manufacturing such a board**

(30) Priority: 17.02.1995 JP 29704/95
(71) Applicant: INTERNATIONAL BUSINESS MACHINES CORPORATION, Armonk, NY 10504 (US)
(72) Inventor: Mizumoto, Shogo, Ohtsu-shi, Siga-ken (JP); Tsukada, Yutaka, Kaga-gun, Shiga-ken (JP)
(74) Representative: Horner, David Richard

(57) **Abstract**

The present invention provides a structure for electrically connecting two or more layers spaced apart from each other in a multilayer printed wiring board, said structure being small in consumed area, tolerant to a high integration, high in the reliability of the process, and good in the yield of products. When forming a via hole in the second insulating layer formed in contact with the first insulating layer having a via hole, a via hole is formed right above the via hole in the first insulating layer. Since the via hole formed in the first insulating layer is filled with a predetermined filler prior to forming the second insulating layer, the consumed area is reducible.

## Description

### Field of the Invention

The present invention relates to the structure of a multilayer printed wiring board and more particularly to a structure, and method of manufacture of such a structure, for forming an electrical connection between none adjacent layers in a multilayer printed wiring board by means of a via hole.

### Background Art

A multilayer printed wiring board is a printed wiring board comprising a plurality of wiring layers. By installing lands for connection in the layers to conduct, forming a through hole penetrating all layers including these layers and coating the through hole with conductive material, a method for electrically connecting a layer located above and a layer below a formed layer of the through hole via a through hole is generally employed to obtain a conduction between layers in a multilayer printed wiring board.

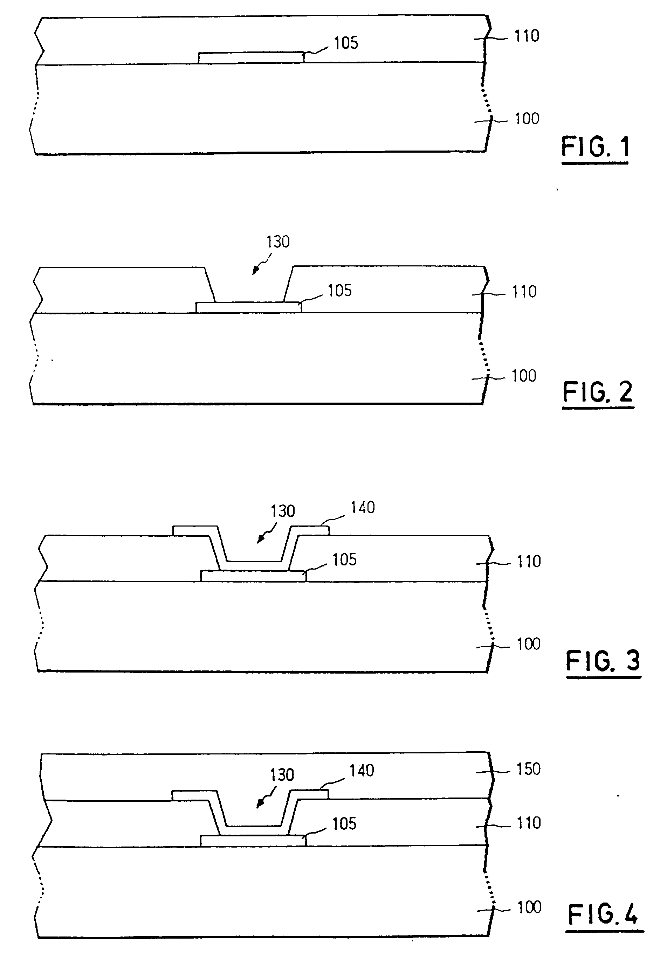

On the other hand, a via hole can also be used as a means for electrically connecting layers. A via hole is a small hole provided in a layer, whose interior is plated with conductive material and which serves to electrically connect the upper and lower layers. For forming a via hole, a buildup method is employed. As shown in Figures 1 to 4, the buildup method is a method for building up a plurality of layers by repeating the process of forming an insulating resin layer, a via hole and plated layer one by one. To take an example, as shown in Figure 1, firstly a photosensitive insulating resin film 110 is applied to a substrate 100 having a connecting land 105. The application is performed by spin coating, screen printing, curtain coating method, and the like. Then, as shown in Figure 2, a via hole 130 is formed on the land 105 by performing an exposure, development, and etching to the photosensitive insulating resin layer in a predetermined pattern. This etching is performed by a dry and/or wet method. Then, as shown in Figure 3, a plated layer 140 is formed with conductive materials on the via hole 130. Furthermore, as shown in Figure 4, the next insulating resin layer 150 is applied to obtain the double layer. If no such hole as a through hole penetrating the substrate needs to be formed, and only holes bored at required places are enough, this method is excellent in that the degree of freedom for wiring is so much the greater.

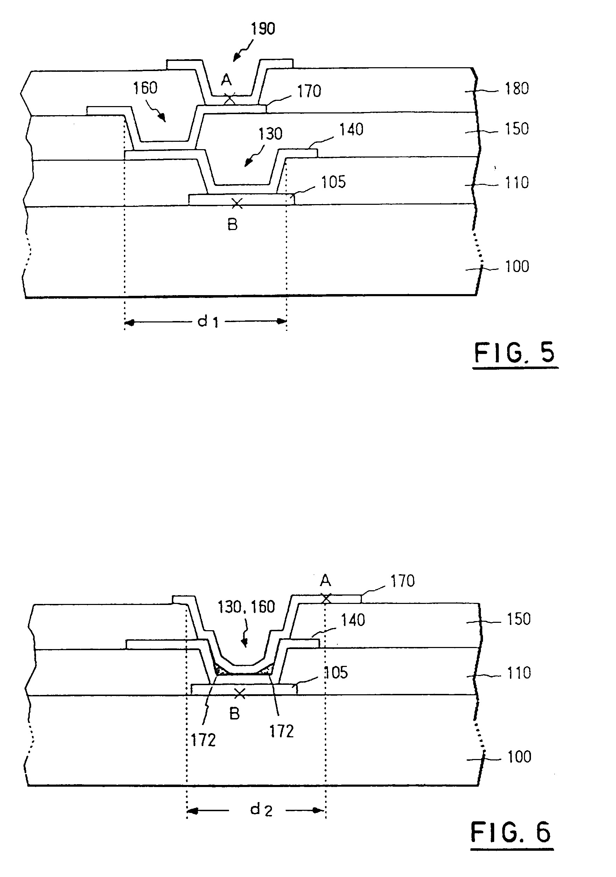

Conventionally in the buildup method, for example, in the case of electrically connecting a point A and a point B on two none adjacent layers 110 and 180 as shown in Figure 5, a second via hole 160 formed on a second insulating layer 150 is situated a little to the side of the position right above a first via hole 130 formed in a first insulating layer 110 and the two layers are electrically connected through plated layers 140 and 170. Also between a second insulating layer 150 and a third insulating layer 180, a third via hole 190 is similarly formed on the third insulating layer 180 a little to the side of the second via hole 160 in the second insulating layer 150. With this approach of the background art, a via hole is formed which is not right above another via hole existing already to electrically connect the two none adjacent layers.

In such a structure, however, an area proportional to nearly a square of d₁ is required in order to electrically connect a point A and a point B through a via hole as shown in Figure 5, where d₁ is relatively large because the via hole is formed obliquely above, not right above, another existing via hole.

The interlayer connection, involving forming the next via hole obliquely above one via hole as discussed above, does not meet a demand for higher density. In other words, a reduction in area is required for a via hole and its layout. It is also considered for ensuring this requirement to form the two holes right above a certain via hole, for example, as shown in Figure 6. As shown in Figure 6, this is so structured that a first via hole 130 is formed on a first insulating layer 110 and a second via hole 160 is formed right above this first via hole by etching a second insulating layer 150. Then, a plated layer 170 is formed on the second via hole 160 and so conduction between a point A on the second insulating layer and a point B on the first insulating layer is achieved. The problems in building up via holes in this way are as follows.

First, above all, the second insulating layer 150 is etched by a wet method or the like in forming a second via hole 160 and this etching takes much time because of requiring above double the depth for a normal via hole. When performing a long-durating etching, etching occurs not only in the depth direction but also in the radial direction and thus the diameter d₂ of a hole becomes large. As with the former example, a consumed area for connecting the point A and the point B can be estimated to be about a square of d₂, but this area becomes almost similar to the area, about a square of d₁, required for electrically connecting the upper and lower layers following the conventional method (cf. Figure 5).

The second problem is in that etching is not always completely performed. If etching is incomplete, the second insulating layer 150 cannot be etched out and remains (172) on the bottom of the first via hole 130. An increase in the amount of such remaining insulating layer 172 damages conduction between the plated layer 140 formed on the first via hole 130 and a plated layer 170 to be formed on the second via hole, thereby lowering the reliability.

Thus, the method of simply forming another via hole on top of one via hole cannot meet the requirements by any means from the aspects of consumed area and reliability.

As a structure for electrically connecting two none adjacent layers, methods which use no via hole are also considered. A way of using a post called stud composed of conductive materials is representative of them. The process of this stud method will be described in Figures 7 to 11. First, after applying a resist 210 or the like on the substrate 200 and forming an opening in a predetermined pattern thereon, metal or other conductive materials 220 is filled in the opening by using a technique such as plating as shown in Figure 7. Thereafter, as shown in Figure 8, the resist 210 is removed by using an appropriate method in order to leave only the stud 220 composed of metal or other conductive materials. Then, as shown in Figure 9, an insulating resin layer 230 is formed in such a manner as to completely cover this stud 220 and the surface is then smoothed as shown in Figure 10. Repeating this process, a structure for electrically connecting two points A and B as shown in Figure 11 can be obtained. Since this technique comprises no etching, unlike the methods mentioned above, it only has a small consumed area (proportional to a square of d₃) in the structure required for electrically connecting the points A and B. From this viewpoint, the advantage for carrying out an integration is great.

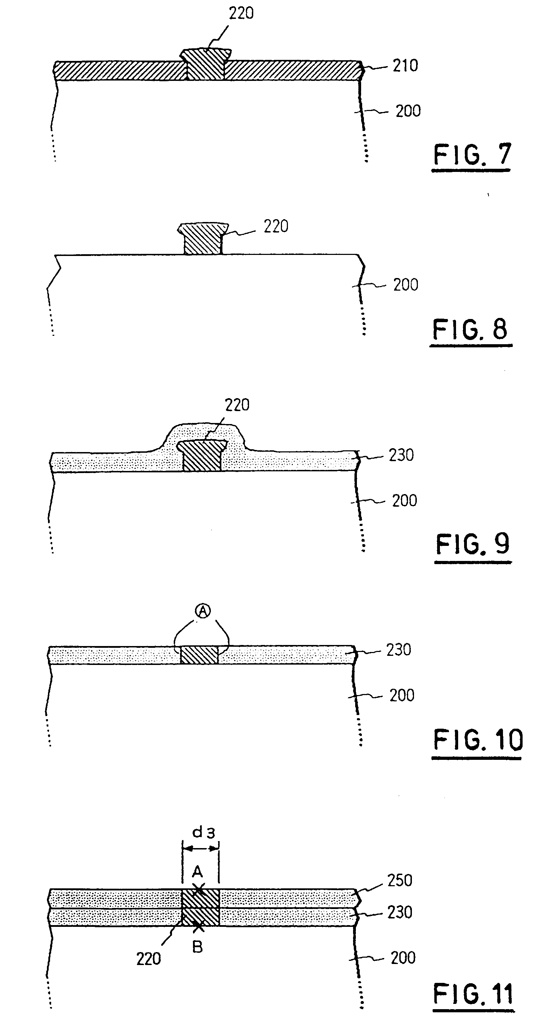

However, this method also has disadvantages. First of all, because the insulating layer 230 is applied without supporting the stud 220 as shown in Figure 8 and Figure 9, collapse of the stud is likely to occur. Collapse of the stud 220 causes an intended electrical connection to be lost at that place, thereby bringing about adverse effects such as misoperation on a finished product. In particular, on a printed wiring board, if collapse occurs even at one place, misoperation or other damage is possible, thus affecting the reliability very greatly. Secondly, as shown in Figure 10, it is difficult to secure the joining strength of an interface A between the insulating resin layer 230 and the metal stud 220. The joining strength lowers due to slight amounts of impurities such as dust mixed into the interface, thereby causing the interface to be separated and a gap to appear, with the effect that corrosion occurs. For these reasons, this method has a large disadvantage in the reliability of products. This disadvantage leads to a decrease in yield.

Considering the above discussed problems with the background art, an object of the present invention is to provide an improved structure for electrically connecting two or more layers in a multilayer printed wiring board and more particularly for electrically connecting two points via at least one layer.

### Summary of the Invention

Viewed from a first aspect, the present invention provides a multilayer printed wiring board, comprising: a first insulating layer with a first via hole formed therein, a first conductive layer being formed in the first via hole, and the first via hole being filled with a filler; and a second insulating layer formed above and in contact with said first insulating layer and having a second via hole located above said first via hole, a second conductive layer in said second via hole being electrically connected with the first conductive layer.

The present invention provides a multilayer printed wiring board comprising: a first insulating layer having a via hole filled with filler; and a second insulating layer formed in contact with the first insulating layer wherein a via hole formed in the second insulating layer is situated right above the via hole formed in the first insulating layer.

Also, the via hole formed in the second insulating layer may be filled with filler. This filler is preferably metal material but may be metal paste or resin. Especially recommended as a filler is copper from the standpoint of being similar in quality to the plating layer.

According to such a structure, since a first point (point A) on the second insulating layer and a second point (point B) in the first insulating layer are electrically connected through a plated layer on the via hole formed in the first insulating layer and a plated layer on the via hole in the second insulating layer, the object of the present invention can be achieved.

The present invention provides a structure with a small consumed area and consequently enables a highly integrated wiring to be achieved. Additionally it provides a structure which can be reliably produced, and for which the yield of products is good.

Viewed from a second aspect the present invention provides a method of manufacturing a multilayer printed wiring board, comprising the steps of: forming a first via hole at a predetermined position in a first insulating layer disposed on the board; forming a first conductive layer in said first via hole; filling said via hole with filler; smoothing the surface of said printed wiring board after said filling step; and performing a pattern formation of said first conductive layer.

### Brief Description of the Drawings

The present invention will be described further, by way of example only, with reference to a preferred embodiment thereof as illustrated in the accompanying drawing, in which:
Figures 1 to 4 are process drawings showing a method for forming a via hole according to the buildup method of the background art;
Figure 5 is a sectional view of an electrical connection using a via hole formed by the buildup method in the background art;
Figure 6 is a sectional view of the structure of layer-built via holes according to the background art;
Figures 7 to 11 are process drawings showing a method for forming an electrical connection according to the stud method of the background art;

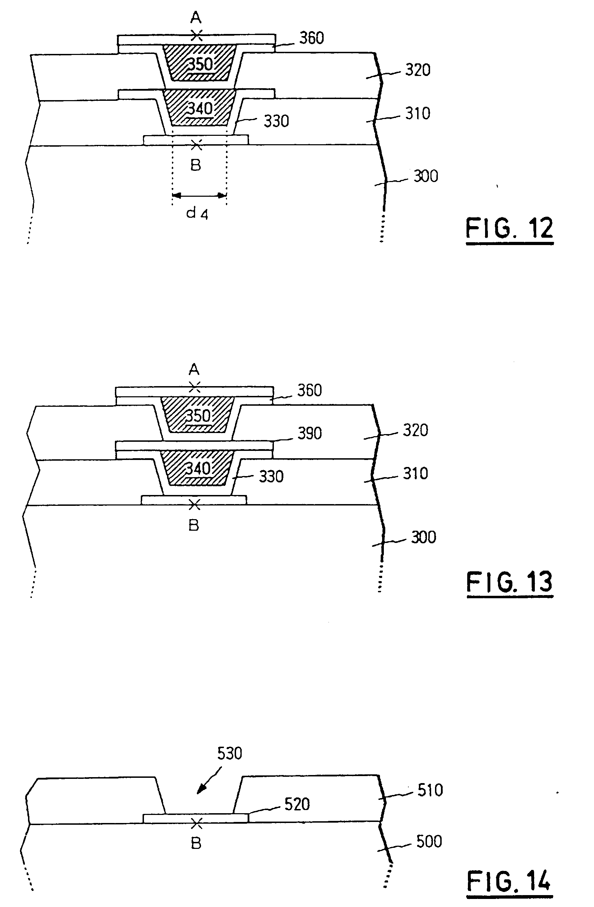

Figure 12 is a sectional view of layer-built via holes according to a preferred embodiment of the present invention;
Figure 13 is a sectional view of layer-built via holes according to a preferred embodiment of the present invention; and
Figures 14 to 19 are process drawings showing a method for forming layer-built via holes according to preferred embodiments of the present invention.

### Description of Preferred Embodiment

Figure 12 shows the structure of a preferred embodiment of the present invention. This is a structure in which a plated layer 330 made of a conductive material is provided on a first via hole formed in the first insulating layer 310 on the substrate 300 and then the first via hole 340 is filled with metal, metal paste, resin, or the like. This filled structure has a smoothed surface, on which a second insulating layer 320 is also formed. Formed on the second insulating layer 320 are a second via hole 350 and further a plated layer 360 on it, where the second via hole 350 is formed nearly right above the filled first via hole 340. As a result, the area needed for electrically connecting the point A and point B is proportional to approximately a square of the diameter d₄ of the via hole, but it is similar to that of an ordinary via hole and therefore the consumed area does not increase even if two points related to two none adjacent layers are electrically connected.

If via holes are stacked in such a structure, the consumed area can be suppressed to quite the same area not only when electrically connecting two points with one layer sandwiched therebetween but also when electrically connecting two points with two or more layers sandwiched therebetween. That is because it is only necessary to stack a desired number of such filled via holes as shown in Figure 12.

The filler material is preferably metal. In particular, the same metal element as the plated layer is preferred from the standpoint of preventing corrosion, and thus copper is most frequently used. The reason why conductive materials such as metal materials are preferable is a probable raise in the reliability of electrical connection due to use of a filler material that serves to fill up a via hole and at the same time can bear a conductivity, viewed from the object of the present invention lying in electrically connecting two points on two none adjacent layers. When using a conductive material as filler material like this, the conducting path is formed in the sequence of the point A - the plated layer 360/the filler material 350 - the filler material 340/the plated layer 330 - the point B.

One aspect of the present invention is that filling and smoothing a formed via hole enables another via hole to be formed right above the filled via hole. From this viewpoint, a filler may not necessarily be conductive if capable of filling. Consequently, a metal paste, not as conductive as metal, or a resin material, not conductive, can achieve the advantages of the present invention. Figure 13 shows a structure when using an insulating material, such as resin, or a poorly conductive material, such as metal paste, as the filler. This structure is in principle the same as the one shown in Figure 12 when using a metal as filler, but differs only in that a conductive material layer 390 is formed between the plated layer 330 formed on the first via hole 340 and the filled second via hole 350. This conductive material layer forms a good conducting path between the point A and the point B. The conducting path in this structure is formed in the sequence of the point A - the plated layer 360 - the conductive material layer 390 - the plated layer 330 - the point B.

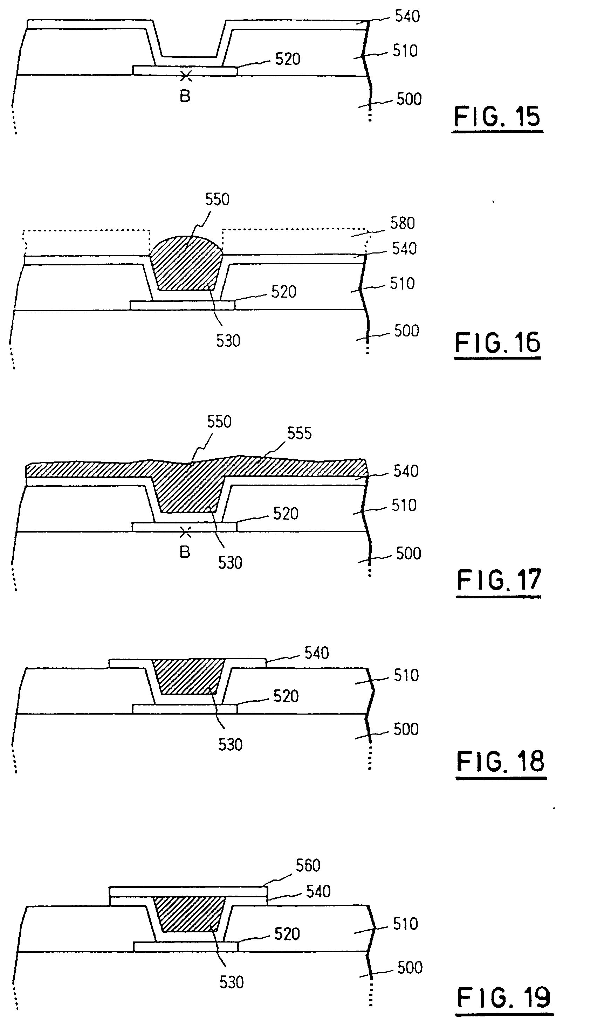

Next, a method for obtaining such a structure will be described. As shown in Figure 14, a first via hole 530 is formed by etching the first insulating layer 510 right above the point B to be connected with the electrode 520 on the substrate 500. This via hole can be formed by an ordinary method comprising applying a resist, developing, and so on. Then, as shown in Figure 15, a plated layer 540 made of copper or other metal material is overall formed on the first via hole 530 to implement a conduction with the point B. The next process differs depending upon what is selected as a filler. When using metal as filler, coat the portion other than the via hole with a stop-off resist 580 so that a metal-plated layer 550 may be formed in the via hole alone in the next plating process. Then, remove the stop-off resist 580. On the other hand, when using a paste-like material as filler, spread a paste onto the whole surface by using a squeezer or the like or fill a filler 550, such as metal paste or resin paste, in the via hole 530 by screen photoprint as shown in Figure 17. At this point, it is usually impossible to fill a filler into the first via hole neither too much nor too less. Since a filler rises on the via hole (Figure 16) or remains in the neighbouring portion like 555 (Figure 17), surface grinding is carried out according to the degree of necessity to smooth the surface. Finally, on patterning the copper plating, such a structure as shown in Figure 18 is obtained. At that time, on patterning after further plating with copper, such a structure as shown in Figure 19 is obtained and a second plated layer 560 is further formed on the first plated layer 540. Piling the structure of Figure 18 in double layers leads to a structure shown in Figure 12 and piling the structure of Figure 19 in double layers leads to a structure shown in Figure 13. In other words, by repeating this process concerning a plurality of layers, a desired piled via hole structure is obtained. At that time, it is important for obtaining the inventive structure to form a second via hole right above the first via hole.

Finally, the degree of reduction in consumed area that is achieved in accordance with preferred embodiments of the present invention when connecting two points on a plurality of none adjacent layers will be illustrated. The consumed area is considered to be proportional to a square of d₁ for the background art, to a square of d₂ for the case of boring a via hole right above the via hole in the lower layer without filling the lower via hole, to a square of d3 for the case of stud method, and to a square of d₄ for the case of the preferred embodiments of the present invention.

| | d₁ | d₂ | d₃ | d₄ |
|---|---|---|---|---|
| d (mm) | 0.25 | 0.45 | 0.15 | 0.12 |
| square of d | 0.0625 | 0.205 | 0.0225 | 0.0144 |
| (dn/d4)² | 4.34 | 14.24 | 1.56 | - |

From the above chart, it is clear that the preferred embodiment of the present invention enables an equivalent connection between points with about a quarter of the consumed area for the background art. The preferred embodiment of the present invention is clearly superior to the stud method.

A method according to the preferred embodiment of the present invention enables two points on a plurality of none adjacent layers to be connected with each other by filling the via hole and forming a new via hole right above the filled via hole. The diameter of the via hole does not become larger than is needed because no deeper etching than an ordinary method for forming a via hole is performed, and the consumed area is equal to that for a via hole in a single layer as well, thus enabling the integration to be attained. Further, the reliability of the process is higher than the stud method or other background arts and accordingly the yield of products can be enhanced. Furthermore, according to the inventive method of the preferred embodiment, the advantages are very great in that no change is found in consumed area even if there are two or more layers between the plurality of none adjacent layers to be connected.

## Claims

1. A multilayer printed wiring board, comprising:
a first insulating layer (310) with a first via hole (340) formed therein, a first conductive layer (330) being formed in the first via hole (340), and the first via hole (340) being filled with a filler; and
a second insulating layer (320) formed above and in contact with said first insulating layer (310) and having a second via hole (350) located above said first via hole, a second conductive layer (360) in said second via hole (350) being electrically connected with the first conductive layer (330).

2. A multilayer printed wiring board as claimed in Claim 1, wherein the filler is formed of electrically conducting material and said electrical connection between the first (330) and second (360) conductive layers is provided via said filler.

3. A multilayer printed wiring board as claimed in Claim 2, wherein said filler consists of metal material.

4. The multilayer printed wiring board as claimed in Claim 3, wherein said filler consists of copper.

5. A multilayer printed wiring board as claimed in Claim 1, wherein said electrical connection between the first (330) and second (360) conductive layers is provided via a conductive layer (390) provided on said filler between said first (330) and second (360) conductive layers.

6. A multilayer printed wiring board as claimed in Claim 5, wherein said filler consists of metal paste or resin.

7. A multilayer printed wiring board as claimed in any preceding claim, wherein said second via hole (350) is filled with said filler.

8. A method of manufacturing a multilayer printed wiring board, comprising the steps of:
forming a first via hole (340) at a predetermined position in a first insulating layer (310) disposed on the board;
forming a first conductive layer (330) in said first via hole (340);
filling said via hole (340) with filler;
smoothing the surface of said printed wiring board after said filling step; and
performing a pattern formation of said first conductive layer (330).

9. A method as claimed in Claim 8, further comprising the steps of:
forming a second insulating layer (320) on said first insulating layer (310);
forming a second via hole (350) in said second insulating layer located above said first via hole (340); and
forming a second conductive layer (360) in said second via hole (350).
